# EUROPEAN PATENT SPECIFICATION

(11) **EP 3 712 708 B1**
(45) Date of publication and mention of the grant of the patent: **12.10.2022**
(21) Application number: 20156146.1
(22) Date of filing: 07.02.2020
(51) Int. Cl.: G03G 21/16, G03G 21/18

(54) **ERRONEOUS MOUNTING PREVENTION SYSTEM**
SYSTEM ZUR VERHINDERUNG VON FEHLMONTAGEN
SYSTÈME DE PRÉVENTION DE MONTAGE ERRONÉ

(30) Priority: 27.02.2019 JP 2019034906
(43) Date of publication of application: 23.09.2020
(73) Proprietor: CANON KABUSHIKI KAISHA, OHTA-KU Tokyo 146-8501 (JP)
(72) Inventor: KAMOSHIDA, Shigemi, Ohta-ku, Tokyo 146-8501 (JP); KOISHI, Isao, Ohta-ku, Tokyo 146-8501 (JP); YAMAMOTO, Daisuke, Ohta-ku, Tokyo 146-8501 (JP)
(74) Representative: Canon Europe Limited

(56) References cited:
- US-A1- 2014 086 628
- US-A1- 2017 153 596

## Description

### BACKGROUND OF THE INVENTION

### Field of the Invention

The present invention relates to a system for preventing erroneous mounting of a cartridge on an apparatus main body of an image forming apparatus.

### Description of the Related Art

There has been widely known a configuration improving replacement convenience by combining process units, such as a photosensitive drum, and consumables, such as a toner container, into a single cartridge, for an electrophotographic image forming apparatus.

Meanwhile, there may be a plurality of types of cartridges and a plurality of types of apparatus main bodies for image forming apparatuses. Japanese Patent No. 06049376 discusses an erroneous mounting prevention mechanism for preventing a cartridge incompatible with the apparatus main body from being mounted on the apparatus main body in this case. US 2014/086628 A1 discloses another example of an erroneous mounting prevention system.

### SUMMARY OF THE INVENTION

According to a first aspect of the present invention, there is provided erroneous mounting prevention system as specified in claims 1 to 4.

Further features of the present invention will become apparent from the following description of embodiments with reference to the attached drawings.

### BRIEF DESCRIPTION OF THE DRAWINGS

Figs. 1A, 1B, 1C, and 1D are perspective diagrams and partial detailed diagrams illustrating mounting of a cartridge onto an image forming apparatus, respectively.
Fig. 2 is a cross-sectional diagram schematically illustrating the image forming apparatus.
Fig. 3 is a cross-sectional diagram schematically illustrating the cartridge.
Fig. 4 is an exploded diagram of the cartridge.
Fig. 5 is an exploded diagram of the cartridge.
Figs. 6A and 6B are perspective diagrams of the image forming apparatus.
Figs. 7A and 7B are cross-sectional diagrams schematically illustrating the image forming apparatus.
Figs. 8A and 8B are cross-sectional diagrams schematically illustrating the image forming apparatus.
Figs. 9A, 9B, and 9C are a schematic diagram illustrating the image forming apparatus viewed from a direction in which the cartridge is mounted, and partial diagrams viewed from directions indicated by arrows, respectively.
Figs. 10A, 10B, 10C, 10D, and 10E are diagrams illustrating an operation of an erroneous mounting prevention mechanism when a compatible cartridge is inserted into the image forming apparatus.
Fig. 11 is a diagram illustrating an operation of the erroneous mounting prevention mechanism when an incompatible cartridge is inserted into the image forming apparatus.
Figs. 12A and 12B are diagrams illustrating an operation of the erroneous mounting prevention mechanism when a compatible cartridge is inserted into the image forming apparatus.
Fig. 13 is a diagram illustrating an operation of the erroneous mounting prevention mechanism when an incompatible cartridge is inserted into the image forming apparatus.
Figs. 14A and 14B are diagrams illustrating an example of a configuration of an identification pattern of the image forming apparatus.

### DESCRIPTION OF THE EMBODIMENTS

A cartridge and an image forming apparatus according to an embodiment of the present invention will be described with reference to the drawings. In the following description, the image forming apparatus and the cartridge will be described, using a laser beam printer and a cartridge used in the laser beam printer as examples thereof.

In the following description, a longitudinal direction Y is defined to match a direction along a rotational axis of a photosensitive drum, which is an image bearing member. Further, a driven side and a non-driven side are defined to refer to a side to which driving is transmitted from a main body of the image forming apparatus to the photosensitive drum and an opposite side therefrom in the longitudinal direction Y, respectively.

Further, the reference numerals in the description are intended to facilitate the reference to the drawings, and are not intended to limit the configuration.

### [Overall Configuration of Image Forming Apparatus]

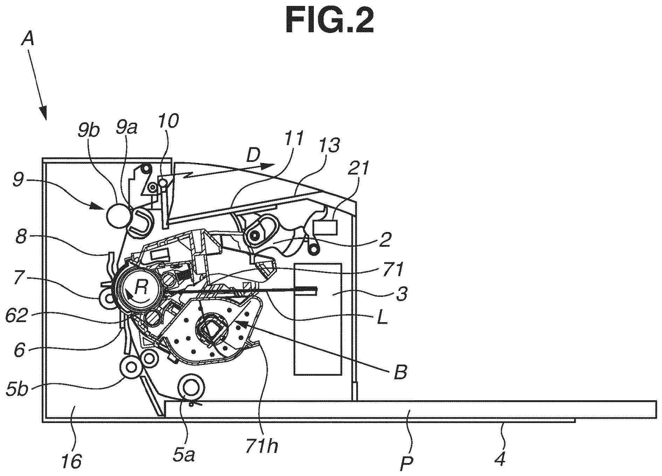

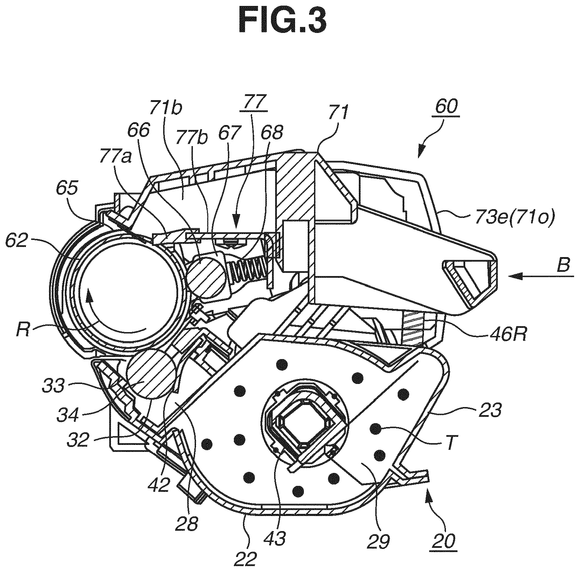

A configuration in common between a first apparatus main body A1 and a second apparatus main body A2, and a configuration in common between a first cartridge B1 and a second cartridge B2, in configurations of an apparatus main body and a cartridge of an image forming apparatus according to a first embodiment, will be described with reference to Figs. 2 and 3. Hereinafter, a configuration described as the apparatus main body A will indicate the configuration in common between the first apparatus main body A1 and the second apparatus main body A2, and a configuration described as the cartridge B will indicate the configuration in common between the first cartridge B1 and the second cartridge B2.

Fig. 2 is a cross-sectional diagram of the apparatus main body A and the cartridge B. Fig. 3 is a cross-sectional diagram of the cartridge B. The apparatus main body A refers to the image forming apparatus with the cartridge B removed therefrom.

The image forming apparatus illustrated in Fig. 2 is a laser beam printer which the cartridge B is attachable to and detachable from the apparatus main body A, and using the electrophotographic technique.

A sheet tray 4, on which a recording medium used to form an image thereon (hereinafter referred to as a "sheet P") is stacked, is disposed vertically below the cartridge B.

Further, a pickup roller 5a, a pair of feeding rollers 5b, a transfer guide 6, a transfer roller 7, a conveyance guide 8, a fixing device 9, a pair of discharge rollers 10, a discharge tray 11, and the like are disposed in the apparatus main body A in series along a direction D in which the sheet material P is conveyed. The fixing device 9 includes a heating roller 9a and a pressing roller 9b.

### [Image Forming Process]

Next, an image forming process will be schematically described. A photosensitive drum 62 is rotationally driven at a predetermined circumferential speed (process speed) in a direction indicated by an arrow R based on a print start signal.

A charging roller (charging member) 66 with a bias voltage applied thereto is in contact with an outer peripheral surface of the photosensitive drum 62, and evenly charges the outer peripheral surface of the photosensitive drum 62.

A laser scanner 3 as an exposure device outputs laser light L based on image information. This laser light L passes through a laser opening 71h provided on a drum frame member 71 of the cartridge B, and scans and exposes the outer peripheral surface of the photosensitive drum 62. As a result, an electrostatic latent image based on the image information is formed on the outer peripheral surface of the photosensitive drum 62.

On the other hand, as illustrated in Fig. 3, toner T in a toner chamber 29 is stirred and conveyed by a rotation of a conveyance member (stirring member) 43 and is fed out to a toner supply chamber 28 in a development unit 20 as a development device.

The toner T is borne on a surface of a development roller 32 due to a magnetic force of a magnet roller 34 (stationary magnet). The development roller 32 is a developer bearing member that bears a developer (toner T) on a surface thereof to develop the latent image formed on the photosensitive drum 62. While the toner T is triboelectrically charged by a development blade 42, a layer thickness of the toner T is regulated on the circumferential surface of the development roller 32 as the developer bearing member. The toner T is supplied to the photosensitive drum 62 based on the electrostatic latent image, and develops the latent image. As a result, the latent image is visualized as a toner image. The photosensitive drum 62 is an image bearing member that bears the latent image and the toner image, which is an image formed with the toner T, on the surface thereof. Further, as illustrated in Fig. 2, the sheet material P stored in a lower portion of the apparatus main body A is fed out from the sheet tray 4 by the pickup roller 5a and the pair of feeding rollers 5b in synchronization with a timing at which the laser light L is output. Then, this sheet material P is conveyed to a transfer position between the photosensitive drum 62 and the transfer roller 7 via the transfer guide 6. The toner image is sequentially transferred from the photosensitive drum 62 onto the sheet material P at this transfer position.

The sheet material P with the toner image transferred thereon is separated from the photosensitive drum 62 and conveyed to the fixing device 9 along the conveyance guide 8. Then, the sheet material P passes through a fixing nip portion formed by the heating roller 9a and the pressing roller 9b that form the fixing device 9. The sheet material P with the toner image formed thereon is subjected to pressing and heating fixing processing at this fixing nip portion, and thereby the toner image is fixed onto the sheet material P. The sheet material P subjected to the processing for fixing the toner image is conveyed to the pair of discharge rollers 10 and discharged onto the discharge tray 11.

On the other hand, as illustrated in Fig. 3, the photosensitive drum 62 after the transfer is subjected to removal of residual toner on the outer peripheral surface therefrom by a cleaning blade 77, and is used for the image forming process again. The toner T removed from the photosensitive drum 62 is stored in a waste toner chamber 71b of a drum unit 60. The drum unit 60 is a unit including the photosensitive drum 62.

In the above-described configuration, the charging roller 66, the development roller 32, the transfer roller 7, and the cleaning blade 77 are process units that work on the photosensitive drum 62.

### [Overall Configuration of Cartridge]

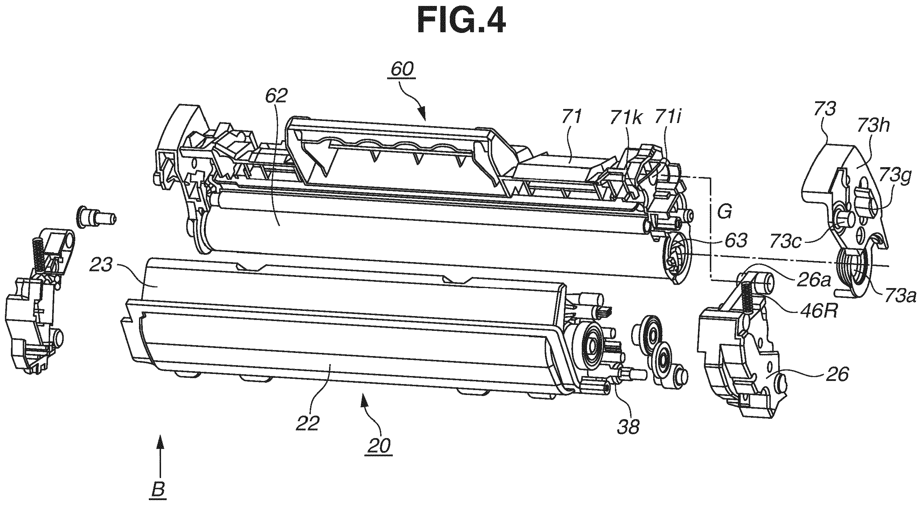

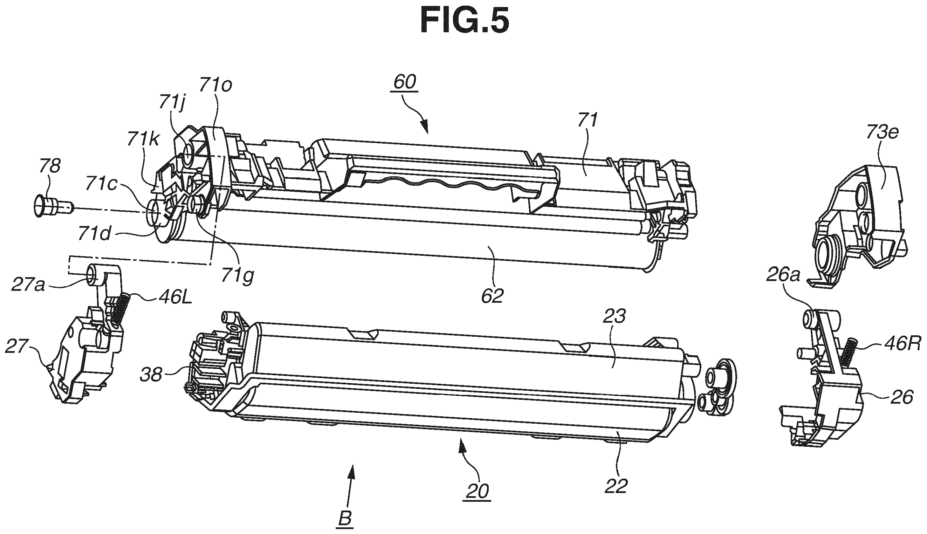

Next, an overall configuration of the cartridge B will be described with reference to Figs. 3, 4, and 5. Fig. 3 is a cross-sectional view of the cartridge B, and Figs. 4 and 5 are perspective diagrams illustrating the configuration of the cartridge B.

The cartridge B includes the drum unit 60 and the development unit 20. The cartridge B is a unit formed by unitizing (combining) the photosensitive drum 62 and at least one of the process units working thereon into a cartridge. The cartridge B is configured to be attachable to and detachable from the apparatus main body A of the image forming apparatus. Examples of the process units include the charging unit, the development unit, and the cleaning unit.

As illustrated in Fig. 3, the drum unit 60 includes the photosensitive drum 62, the charging roller 66, the cleaning blade 77, and the drum frame member 71 supporting them. On the photosensitive drum 62, a driven-side drum flange 63 provided on the driven side is rotatably supported by a hole portion 73a of a drum bearing 73 on the driven side as the other end side (refer to Fig. 4). In a broad sense, the drum bearing 73 and the drum frame member 71 can also be collectively referred to as the drum frame member.

The photosensitive drum 62 is configured in such a manner that a hole portion (not illustrated) of a drum flange on the non-driven side is rotatably supported by a drum shaft 78, which is press-fitted in a hole portion 71c provided on the drum frame member 71, on the non-driven side as one end side as illustrated in Fig. 5.

Each of the drum flanges is a borne portion rotatably supported by the bearing portion. In the drum unit 60, the charging roller 66 and the cleaning blade 77 are each disposed in contact with the outer peripheral surface of the photosensitive drum 62.

The cleaning blade 77 includes a rubber blade 77a, which is a blade-shaped elastic member made of rubber as an elastic material, and a support member 77b supporting the rubber blade 77a. The rubber blade 77a is in abutment with the photosensitive drum 62 in a counter direction to a rotational direction of the photosensitive drum 62. In other words, the rubber blade 77a is in abutment with the photosensitive drum 62 in such a manner that a distal end portion thereof faces an upstream side in the rotational direction of the photosensitive drum 62.

As illustrated in Fig. 3, the waste toner removed from the surface of the photosensitive drum 62 by the cleaning blade 77 is stored in the waste toner chamber 71b formed by the drum frame member 71 and the cleaning blade 77.

Further, as illustrated in Fig. 3, a sheet member 65 for preventing a leak of the waste toner from the drum frame member 71 is provided at an edge portion of the drum frame member 71 so as to abut against the photosensitive drum 62.

The charging roller 66 is rotatably attached to the drum unit 60 via charging roller bearings 67 at both end portions of the drum frame member 71 in the longitudinal direction Y. The charging roller bearings 67 are each pressed toward the photosensitive drum 62 by a biasing member 68, by which the charging roller 66 is in pressure contact with the photosensitive drum 62. The charging roller 66 is driven to be rotated following the rotation of the photosensitive drum 62.

As illustrated in Fig. 3, the development unit 20 includes the development roller 32, a developer container 23 supporting the development roller 32, the development blade 42, and the like. The development roller 32 is rotatably attached to the developer container 23 via bearing members 26 (see Fig. 4) and 27 (see Fig. 5) provided at both ends.

Further, the magnet roller 34 is provided in the development roller 32. The development blade 42 for regulating the toner layer on the development roller 32 is disposed in the development unit 20. As illustrated in Figs. 4 and 5, the development roller 32 is provided with space holding members 38 placed at both of the end portions of the development roller 32, and the development roller 32 is held with an extremely small gap formed between the development roller 32 and the photosensitive drum 62 due to abutment between the space holding members 38 and the photosensitive drum 62. Further, as illustrated in Fig. 3, a development sheet member 33 for preventing the toner T from leaking from the development unit 20 is provided at an edge portion of a bottom member 22 so as to abut against the development roller 32. Further, the conveyance member 43 is provided in the toner chamber 29 formed by the developer container 23 and the bottom member 22. The conveyance member 43 conveys the toner T into the toner supply chamber 28 along with stirring the toner T stored in the toner chamber 29.

As illustrated in Figs. 4 and 5, the cartridge B is formed by joining the drum unit 60 and the development unit 20 to each other.

When the development unit 20 and the drum unit 60 are joined, first, a center of a development first support boss 26a of the bearing member 26 is aligned with a first suspension hole 71i on the driven side of the drum frame member 71, and a center of a development second support boss 27a of the bearing member 27 is aligned with a second suspension hole 71j on the non-driven side. More specifically, the development first support boss 26a and the development second support boss 27a are fitted in the first suspension hole 71i and the second suspension hole 71j, respectively, by moving the development unit 20 in a direction indicated by an arrow G. In this way, the development unit 20 is movably coupled with the drum unit 60. More specifically, the development unit 20 is rotationally movably (rotatably) coupled with the drum unit 60. In other words, the development roller 32 is coupled with the photosensitive drum 62 in a contactable and separable state. After that, the cartridge B is assembled by mounting the drum bearing 73 on the drum unit 60.

In the present embodiment, a driven-side biasing member 46L (see Fig. 5) and a non-driven side biasing member 46R (see Fig. 4) are made of compression springs. The cartridge B is configured to reliably press the development roller 32 in a direction toward the photosensitive drum 62 by causing the driven-side biasing member 46L and the non-driven-side biasing member 46R to bias the development unit 20 toward the drum unit 60 using biasing forces of these springs. Further, the cartridge B includes the space holding members 38 placed at both the end portions of the development roller 32. In other words, the photosensitive drum 62 and the development roller 32 are in contact with each other with a predetermined contact pressure via the space holding members 38, by which the development roller 32 is held while being separated from the photosensitive drum 62 by a predetermined distance and relative positions thereof are determined.

In this case, it is desirable that the distance between the photosensitive drum 62 and the development roller 32 is accurately kept at a constant distance to stably develop the electrostatic latent image on the photosensitive drum 62 with the toner T borne on the circumferential surface of the development roller 32. In other words, the contact pressure should be kept stable when the photosensitive drum 62 and the development roller 32 are in contact with each other via the space holding members 38.

### [Mounting of Cartridge]

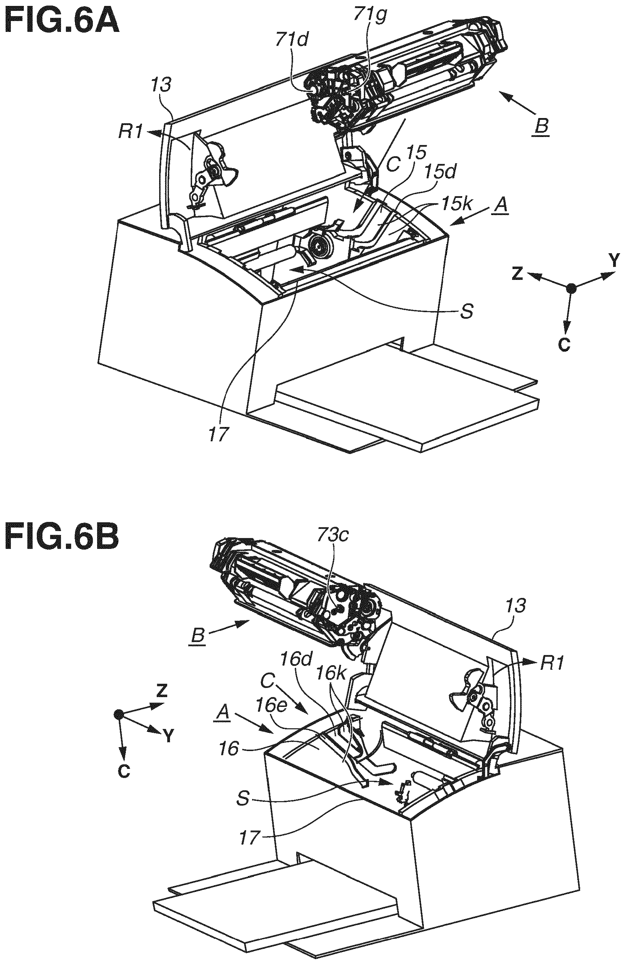

Next, the mounting of the cartridge B onto the apparatus main body A will be specifically described with reference to Figs. 6A to 9C.

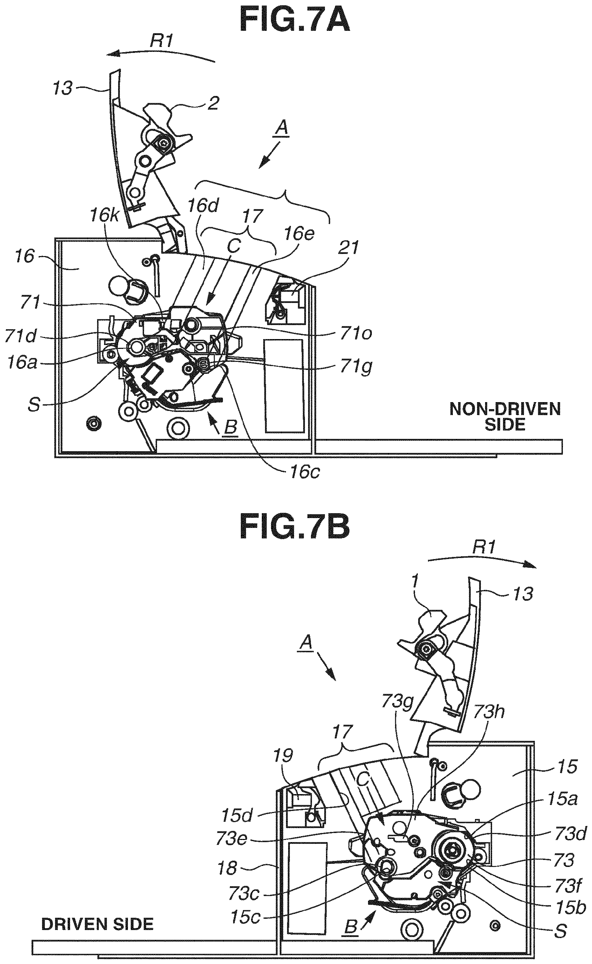

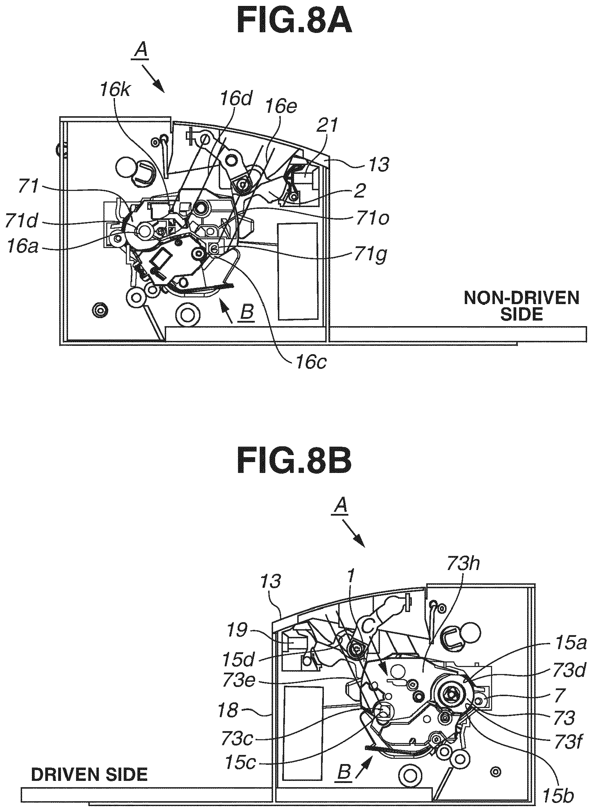

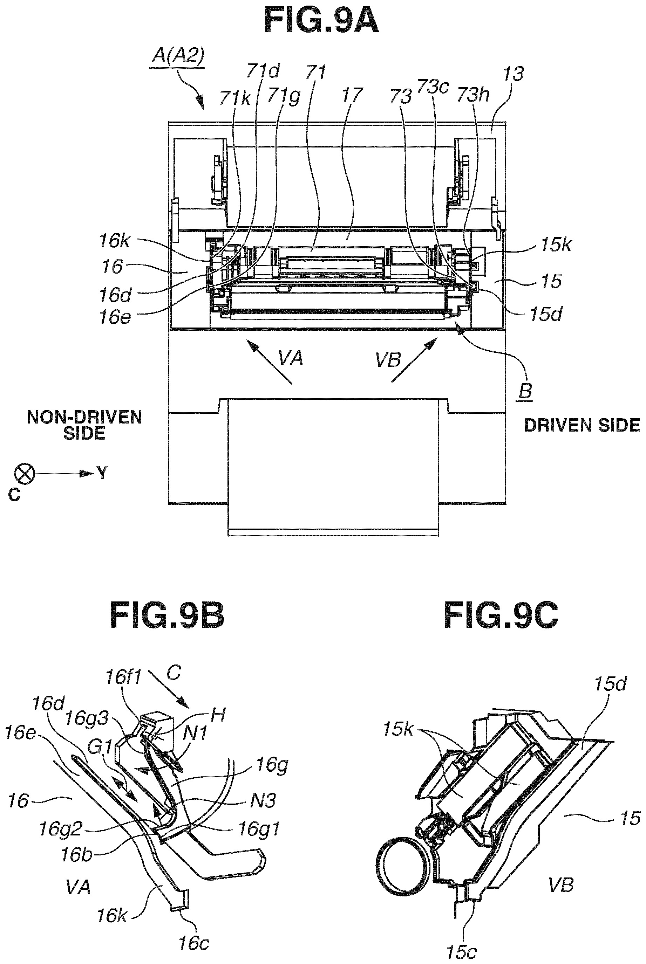

Figs. 6A to 8B illustrate a portion of the apparatus main body A on which the cartridge B is mounted. More specifically, Figs. 6A and 6B are perspective views. Figs. 7A and 8A are side views of the non-driven side. Figs. 7B and 8B are side views of the driven side. Figs. 9A, 9B, and 9C illustrate the image forming apparatus when the cartridge B is mounted on the apparatus main body A, and illustrate the image forming apparatus when a downstream side is viewed from an upstream side in a mounting direction C in which the cartridge B is mounted.

As illustrated in Figs. 6A, 6B, 7A, and 7B, the apparatus main body A is provided with an open/close door 13 for exposing and shielding a mounting portion S on which the cartridge B is mounted. To mount the cartridge B, the mounting portion S on which the cartridge B is mounted and a cartridge insertion port 17, which is an entrance when the cartridge B is mounted, are exposed by rotating the open/close door 13 in a direction indicated by an arrow R1. This allows the cartridge B to be mounted on the apparatus main body A in a direction intersecting the longitudinal direction Y (mounting direction C). The mounting portion S is a portion on which the cartridge B is mounted eventually in the apparatus main body A. In the present embodiment, the apparatus main body A can form an image by using the cartridge B with the cartridge B mounted on the mounting portion S.

A non-driven-side guide 16 is provided on the non-driven side of the mounting portion S as illustrated in Figs. 6A and 6B, 7A and 7B, and 9A, 9B, and 9C. The non-driven-side guide 16 includes a non-drive-side upper guide 16d and a non-driven-side lower guide 16e cutout along the mounting direction C, and a side surface 16k located on an inner side of the non-driven side that faces the mounting portion S. On the other hand, a driven-side guide 15 is provided on the driven side of the mounting portion S. The driven-side guide 15 includes a side surface 15k located on an inner side of the driven side that faces the mounting portion S, and a driven-side guide portion 15d cutout along the mounting direction C. Further, a guided portion, with which the cartridge B is guided to be mounted onto the apparatus main body A, is provided on the cartridge B.

First, as illustrated in Figs. 9A, 9B, and 9C, and Fig. 5, an end surface 71k intersecting the longitudinal direction Y, a positioned portion (restricted portion) 71d protruding from the end surface 71k outward in the longitudinal direction Y, and a rotation regulating portion 71g are provided on the non-driven side of the drum frame member 71. On the other hand, an end surface 73h intersecting the longitudinal direction Y, and a rotation regulating portion 73c protruding from the end surface 73h outward in the longitudinal direction Y are provided on the drum bearing 73 on the driven side.

As illustrated in Figs. 9A, 9B, and 9C, when the cartridge B is mounted on the apparatus main body A from the cartridge insertion port 17, the end surface 71k on the non-driven side of the cartridge B and the end surface 73h on the driven side face the side surface 16k located on the inner side of the non-driven side and the side surface 15k located on the inner side of the driven side in proximity thereto, respectively. As a result, a position (track) in the longitudinal direction Y during a process of mounting the cartridge B is determined.

Further, the positioned portion (restricted portion) 71d and the rotation regulating portion 71g are guided by the non-driven-side upper guide 16d and the non-driven-side lower guide 16e on the non-driven side of the cartridge B, respectively. The rotation regulating portion 73c is guided by the driven-side guide portion 15d on the driven side of the cartridge B.

When the cartridge B is moved toward the mounting portion S, a position (track) of the cartridge B in a direction intersecting the mounting direction C and the longitudinal direction Y (this direction will be referred to as a vertical direction Z) is determined. In this way, the cartridge B is mounted onto the apparatus main body A following the determined mounting track (the mounting direction C).

Next, how the open/close door 13 is closed will be described. As illustrated in Figs. 7A, 7B, 8A, and 8B, the driven-side guide 15 includes a first positioning portion 15a and a second positioning portion 15b as positioning portions, and a rotation prohibition portion 15c, and the non-driven-side guide 16 includes a positioning portion 16a and a rotation prohibition portion 16c. The drum bearing 73 includes a first positioned portion 73d and a rotation regulated portion 73f.

Further, cartridge pressing members 1 and 2 are rotatably attached at both ends of the open/close door 13 in a direction along a rotational axis of the open/close door 13. Cartridge pressing springs 19 and 21 are attached at both ends of a front plate provided on the apparatus main body A in the longitudinal direction Y. The drum bearing 73 includes a pressed portion 73e as a biasing force reception portion, and the drum frame member 71 includes a pressed portion 71o on the non-driven side. Closing the open/close door 13 causes the pressed portions 73e and 71o of the cartridge B to be pressed by the cartridge pressing members 1 and 2 biased by the cartridge pressing springs 19 and 21 of the apparatus main body A (refer to Figs. 8A and 8B).

With this configuration, the first positioned portion 73d, the rotation regulated portion 73f, and the rotation regulating portion 73c of the cartridge B are brought into abutment with the first positioning portion 15a, the second positioning portion 15b, and the rotation prohibition portion 15c of the apparatus main body A, respectively, on the driven side. As a result, the cartridge B and the photosensitive drum 62 are positioned on the driven side. Further, the positioned portion 71d and the rotation regulating portion 71g of the cartridge B are brought into abutment with the positioning portion 16a and the rotation prohibition portion 16c of the apparatus main body A, respectively, on the non-driven side. In this way, the cartridge B and the photosensitive drum 62 are positioned on the non-driven side.

As described above, the cartridge B is mounted onto the mounting portion S of the apparatus main body A. The above-described configuration is an example of the configuration for determining the position of the cartridge B with respect to the apparatus main body A, and is not described with the intention to set any limit on the unit as the positioning means. The image forming apparatus may be configured to directly work on the positioned portion 71d and the rotation regulating portion 71g on the non-driven side of the cartridge B and the first positioned portion 73d and the rotation regulating portion 73f on the driven side and fix each of the positioning portions.

### [Erroneous mounting Prevention System]

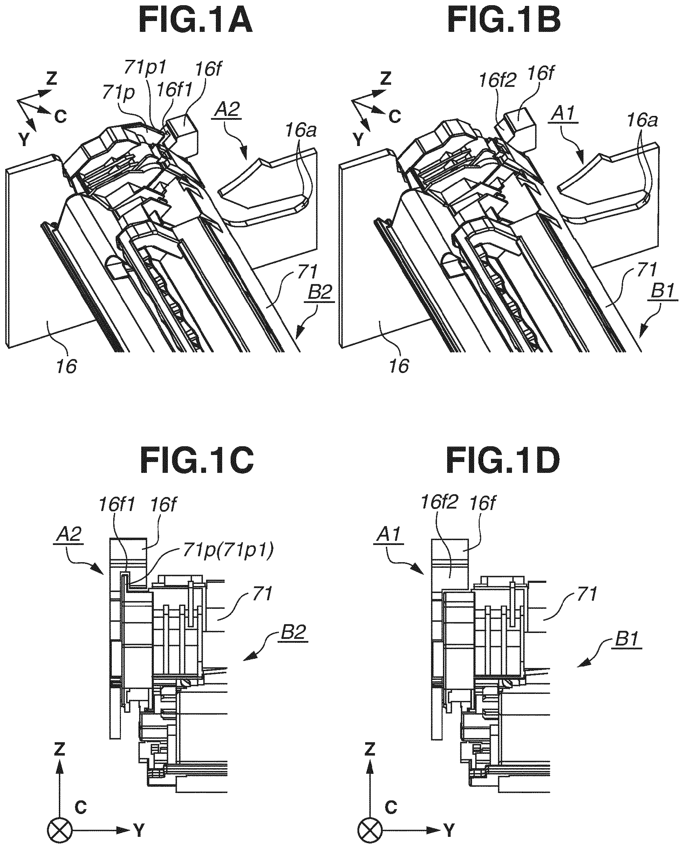

An erroneous mounting prevention system according to the present embodiment will be described with reference to Figs. 9A, 9B, and 9C and Figs. 1A to 13. Figs. 1A to 1D illustrate the erroneous mounting prevention system according to the present embodiment. Figs. 1A and 1C illustrate the second cartridge B2 and the second apparatus main body A2, and Figs. 1B and 1D illustrate the first cartridge B1 and the first apparatus main body A1.

A rib 71p (protruding portion) as an identified portion extending in the direction intersecting the longitudinal direction Y and the mounting direction C (vertical direction Z) is provided at the end portion of the second cartridge B2 on the non-driven side as illustrated in Figs. 1A and 1C.

An identification rail 16f is provided on the second apparatus main body A2. The identification rail 16f includes a cutout portion 16f1 (a recessed portion) as a guide portion, which is provided along the mounting direction C, at a position that matches the rib 71p of the second cartridge B2 in the longitudinal direction Y. Further, a movable lever 16g (restriction member) is provided at the non-driven-side guide 16 on the second apparatus main body A2 as illustrated in Fig. 9B. The movable lever 16g is configured to be rotatable around an axis center H, and is biased in a direction indicated by an arrow N1 by a biasing member (not illustrated). A home position of the movable lever 16g corresponds to a restriction position at which a restricted surface 16g1 of the movable lever 16g is in contact with a restriction surface 16b provided on the non-driven-side guide 16. In other words, the movable lever 16g is located at the restriction position unless the movable lever 16g is moved by applying a force from outside. The movable lever 16g intrudes in a mounting route G1 of the positioned portion 71d of the second cartridge B2 when the movable lever 16g is located at the restriction position. Further, the movable lever 16g includes a first abutted surface 16g3 on the downstream side of the cutout portion 16f1 in the mounting direction C. At the restriction position, the abutment surface 16g3 (first abutted surface) is a surface intersecting the mounting direction C and the direction indicated by the arrow N1 (direction tangential to a circle centered at the axis center H) and having a normal direction extending in the direction indicated by the arrow N1. Further, a lever restriction surface 16g2 is provided near the restricted surface 16g1 of the movable lever 16g. The surface of the lever restriction surface 16g2 (second abutted surface) is a surface intersecting the mounting direction C and having a normal direction extending in a direction indicated by an arrow N3.

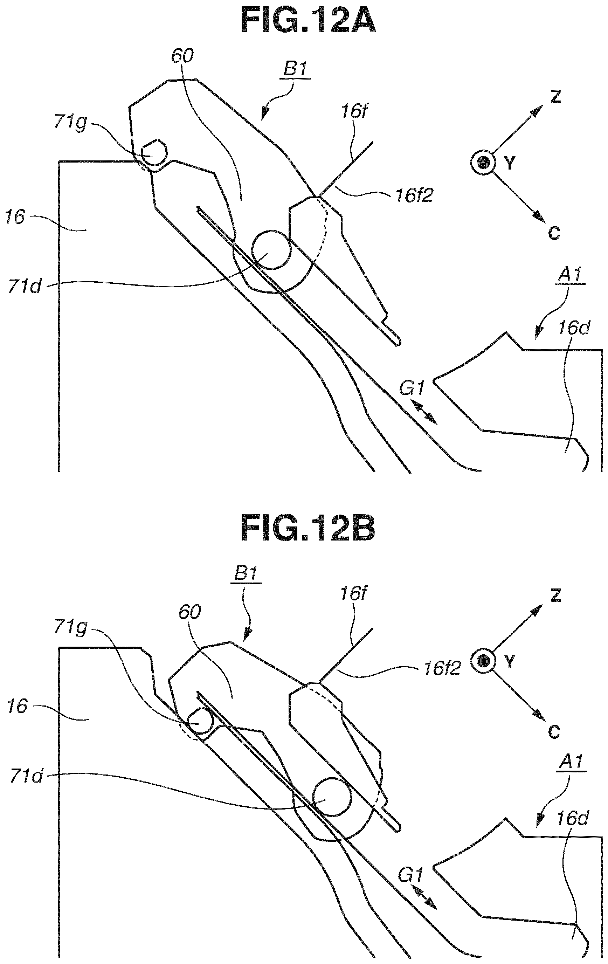

On the other hand, no portion corresponding to the rib 71p of the second cartridge B2 is provided at the end portion of the first cartridge B1 on the non-driven side as illustrated in Figs. 1B and 1D in the present embodiment. Further, the first apparatus main body A1 is provided with no portion corresponding to the cutout portion 16f1 of the second apparatus main body A2, but instead is provided with a surface portion 16f2, which is a surface intersecting the mounting direction C. Further, the first apparatus main body A1 is not provided with a member corresponding to the movable lever 16g of the second apparatus main body A2 as illustrated in Figs. 12A and 12B. A rib or a protruding portion having a height set so as to allow it to pass through below the surface portion 16f2 of the first apparatus main body A1 and prevent it from abutting against the abutted surface 16g3 of the movable lever 16g may be provided at the end portion of the first cartridge B 1 on the non-driven side.

### <Mounting of Second Cartridge B2 onto Second Apparatus Main Body A2>

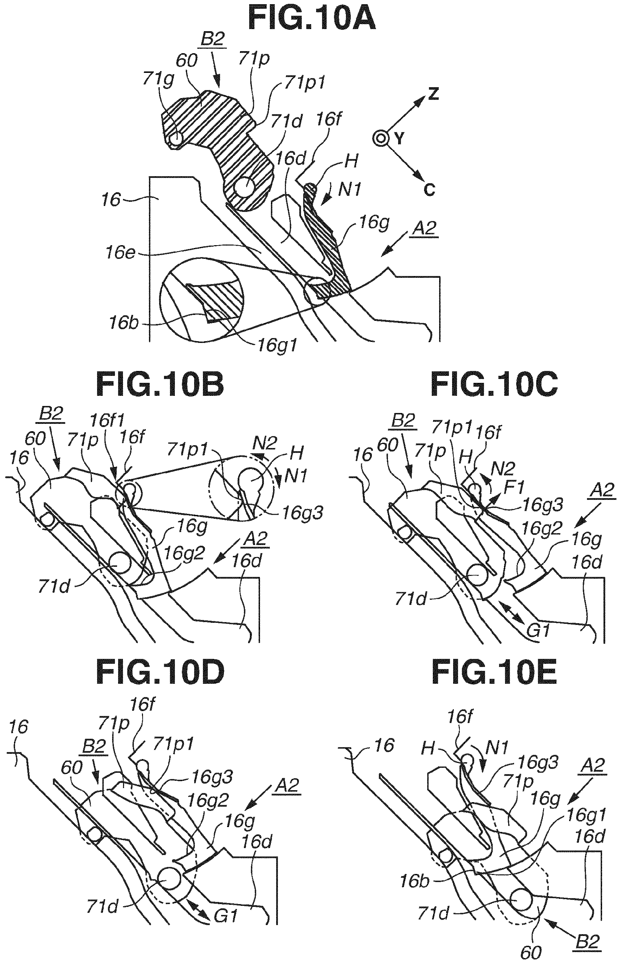

A configuration that allows the second cartridge B2 to be mounted on the second apparatus main body A2 will be described with reference to Figs. 10A, 10B, 10C, 10D, and 10E. Figs. 10A to 10E are cross-sectional diagrams illustrating cross-sections perpendicular to the longitudinal direction Y that illustrate a process of mounting the second cartridge B2 onto the second apparatus main body A2. Figs. 10A to 10E illustrate only the non-driven-side guide 16 and the drum unit 60 for the sake of convenience. Further, only the drum unit 60 and the movable lever 16g are hatched so as to easily understand the shapes of the parts in Fig. 10A, but the hatching is omitted in Figs. 10B to 10E.

As illustrated in Fig. 10B, when the second cartridge B2 is moved in the mounting direction C to mount it on the second apparatus main body A2, the rib 71p (first protruding portion) passes through the cutout portion 16f1 (first recessed portion) of the identification rail 16f. Then, a first abutment portion 71p1 of the rib 71p is brought into abutment with the abutment surface 16g3 of the movable lever 16g. When the second cartridge B2 is further moved in the mounting direction C, a user's force F1 is applied to the abutment surface 16g3 of the movable lever 16g via the first abutment portion 71p1 of the rib 71p. The movable lever 16g is rotated in a direction indicated by an arrow N2 to be moved from the restriction position to a non-restriction position by this force F1. The abutment surface 16g3 of the movable lever 16g is configured to generate a rotational moment in a direction for rotating the movable lever 16g from the restriction position to the non-restriction position when the first abutment surface 71p1 of the rib 71p is brought into abutment therewith.

The non-restriction position is a position to which the movable lever 16g is retracted from the mounting route G1 (Fig. 9B) of the positioned portion 71d of the second cartridge B2. In other words, when the movable lever 16g is located at the non-restriction position, the positioned portion 71d can move without being restricted by the movable lever 16g. When the second cartridge B2 is further moved, the positioned portion 71d passes through the lever restriction surface 16g2 with the rib 71p in abutment with the abutment surface 16g3 and the movable lever 16g located at the non-restriction position as illustrated in Fig. 10D. Then, the rib 71p passes through the abutment surface 16g3, and the mounting of the second cartridge B2 on the second apparatus main body A2 is completed. At this time, because the rib 71p and the abutment surface 16g3 stop abutting against each other, the movable lever 16g is returned by the biasing force of the biasing member (not illustrated) to the restriction position, which is the home position thereof (see Fig. 10E).

In this way, when the second cartridge B2 compatible with the second apparatus main body A2 is mounted onto the second apparatus main body A2, the rib 71p passes through the cutout portion 16f1 of the identification rail 16f and causes the rotation of the movable lever 16g. Then, the movable lever 16g is rotated from the restriction position to the non-restriction position, by which the second cartridge B2 is allowed to be mounted on the second apparatus main body A2 without the positioned portion 71d being restricted by the lever restriction surface 16g2.

### <Mounting of First Cartridge B1 onto Second Apparatus Main Body A2>

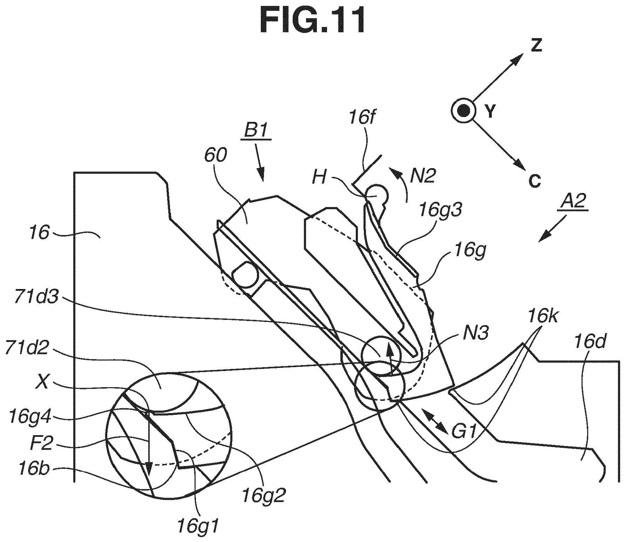

A configuration that prevents the first cartridge B1 from being erroneously mounted on the second apparatus main body A2 will be described. Fig. 11 is a cross-sectional diagram illustrating a cross-section perpendicular to the longitudinal direction Y when the user attempts to mount the first cartridge B1 on the second apparatus main body A2. Fig. 11 illustrates only the non-driven-side guide 16 and the drum unit 60.

Because the first cartridge B1 include no portion corresponding to the rib 71p of the second cartridge B2, the first cartridge B1 is moved in the mounting direction C without the drum frame member 71 interfering with the identification rail 16f on the non-driven side. Further, the first cartridge B1 is moved in the mounting direction C without abutting against the abutment surface 16g3 of the movable lever 16g. The positioned portion 71d of the first cartridge B1 is brought into abutment with the lever restriction surface 16g2 of the movable lever 16g located at the restriction position. Then, a force F2 is applied from the user to the lever restriction surface 16g2 via the positioned portion 71d2. However, because the lever restriction surface 16g2 is the surface having the normal line facing the direction indicated by the arrow N3, the force F2 works in a direction for rotating the movable lever 16g in the direction indicated by the arrow N1 (the direction from the non-restriction position toward the restriction position). The lever restriction surface 16g2 is configured to generate a rotational moment in a direction for rotating the movable lever 16g from the non-restriction position to the restriction position when the positioned portion 71d is brought into abutment therewith.

Accordingly, the movable lever 16g cannot be moved more than that, and is kept in a state intruding in the mounting route G1. Thus, the first cartridge B1 is prevented from being erroneously mounted on the second apparatus main body A2.

### <Mounting of First Cartridge B1 onto First Apparatus Main Body A1>

A configuration that allows the first cartridge B1 to be mounted on the first apparatus main body A1 will be described with reference to Figs. 12A and 12B. The identification rail 16f is provided with no portion corresponding to the cutout portion 16f1 of the second apparatus main body A2, but is provided with the surface portion 16f2 instead of the cutout portion 16f1. On the other hand, because the first cartridge B1 includes no portion corresponding to the rib 71p of the second cartridge B2, the first cartridge B1 is moved in the mounting direction C without interfering with the surface portion 16f2. Further, because the first apparatus main body A1 includes no member corresponding to the movable lever 16g of the second apparatus main body A2, the positioned portion 71d of the first cartridge B1 does not interfere with any portion. Therefore, the first cartridge B1 is allowed to be mounted on the first apparatus main body A1.

### <Mounting of Second Cartridge B2 onto First Apparatus Main Body A1>

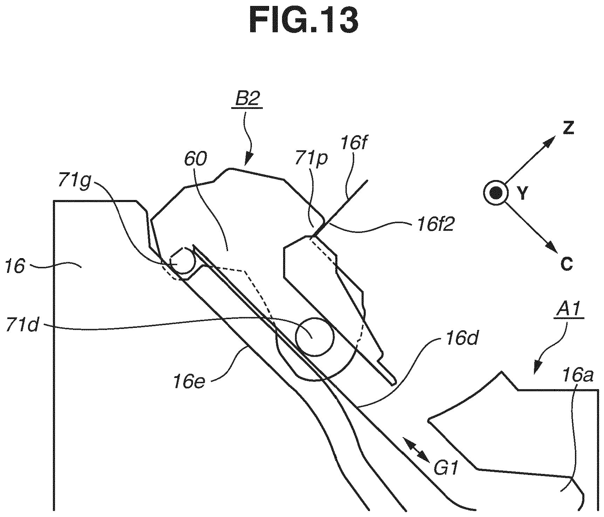

A configuration that prevents the second cartridge B2 from being erroneously mounted on the first apparatus main body A1 will be described with reference to Fig. 13.

As illustrated in Fig. 13, when the user attempts to mount the second cartridge B2 on the first apparatus main body A1, the positioned portion 71d and the rotation regulating portion 71g are guided by the non-driven-side upper guide 16d and the non-driven-side lower guide 16e, respectively. As a result, the position of the second cartridge B2 in the vertical direction Z is determined. When the second cartridge B2 is further moved in the mounting direction C in this state, the rib 71p is brought into abutment with the surface portion 16f2, by which the second cartridge B2 is prohibited from being moved in the mounting direction C and is prevented from being erroneously mounted on the first apparatus main body A1.

### <Third Cartridge B3 and Third Apparatus Main Body A3>

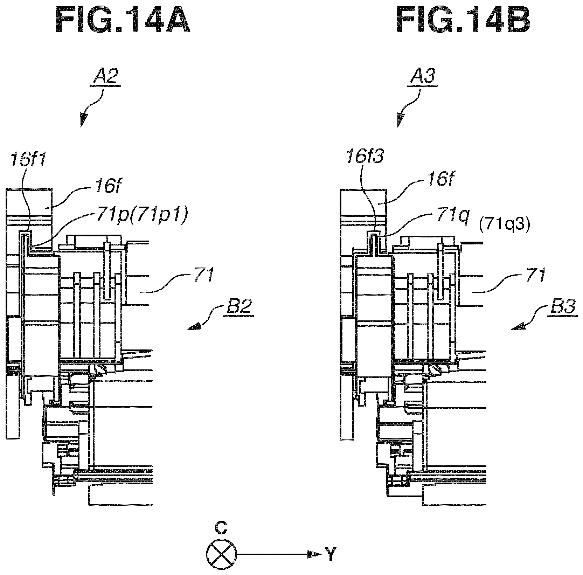

A third apparatus main body A3 and a third cartridge B3, as illustrated in Figs. 14A and 14B, may be provided. The third apparatus main body A3 is equipped with a cutout portion 16f3 (second recessed portion), which is located at a different position from the cutout portion 16f1 of the second apparatus main body A2 in the longitudinal direction Y. The third cartridge B3 is provided with a rib 71q3 (second protruding portion) located at a different position from the rib 71p of the second cartridge B2 in the longitudinal direction Y.

When the user attempts to mount the third cartridge B3 on the first apparatus main body A1, the rib 71q3 is brought into abutment with the surface portion 16f2 and the third cartridge B3 is prohibited from being moved in the mounting direction C, and therefore the third cartridge B3 is prevented from being mounted on the first apparatus main body A1. When the user attempts to mount the third cartridge B3 on the second apparatus main body A2, the result thereof is as follows. Because the rib 71q3 and the cutout portion 16f1 (first recessed portion) of the identification rail 16f are located at the different positions from each other, the rib 71q3 cannot pass through the cutout portion 16f1 and thus the third cartridge B3 is prevented from being mounted on the second apparatus main body A2. When the user attempts to mount the third cartridge B3 on the third apparatus main body A3, the rib 71q3 passes through the cutout 16f3, by which the third cartridge B3 is allowed to be mounted on the third apparatus main body A3.

In the above-described manner, according to the present embodiment, the erroneous mounting prevention system can be constructed using the simply structured apparatus main body (first apparatus main body A1). Further, compatible/incompatible combinations can also be increased by setting the third apparatus main body and the third cartridge.

While the present invention has been described with reference to embodiments, it is to be understood that the invention is not limited to the disclosed embodiments.

## Claims

1. An erroneous mounting prevention system comprising:
a first cartridge (B1) including a first restricted portion (71d);
a second cartridge (B2) including a protruding portion (71p) and a second restricted portion (71d);
a first apparatus main body (A1) configured to allow the first cartridge to be mounted thereon and prevent the second cartridge from being mounted thereon; and
a second apparatus main body (A2) configured to prevent the first cartridge from being mounted and allow the second cartridge to be mounted on the second apparatus main body, the second apparatus main body including a recessed portion (16f1) and a restriction member (16g) configured to be movable between a restriction position in which the first and second cartridges are restricted to be mounted thereon and a non-restriction position in which the first and second cartridges are not restricted to be mounted thereon, **characterized in that**:
the first cartridge includes no portion corresponding to the protruding portion (71p) of the second cartridge at a position corresponding to a position of the protruding portion (71p) of the second cartridge, and the first apparatus main body includes a surface portion (16f2) at a position corresponding to the recessed portion (16f1) of the second apparatus main body and includes no member corresponding to the restriction member (16g) of the second apparatus main body at a position corresponding to a position of the restriction member (16g) of the second apparatus main body,
wherein by moving the second cartridge in a mounting direction to mount the second cartridge on the second apparatus main body, the protruding portion (71p) passes through the recessed portion (16f1) and then is brought into abutment with the restriction member (16g) to move the restriction member (16g) from the restriction position to the non-restriction position, thereby the second restricted portion (71d) passes through a region in which the restriction member (16g) is located when the restriction member is in the restriction position, so that the second cartridge is allowed to be mounted on the second apparatus main body,
wherein by moving the first cartridge in the mounting direction to mount the first cartridge on the second apparatus main body, the first restricted portion (71d) is brought into abutment with the restriction member (16g) located at the restriction position, thereby the first cartridge is restricted to be moved in the mounting direction and is prevented from being mounted on the second apparatus main body,
wherein by moving the second cartridge in the mounting direction to mount the second cartridge on the first apparatus main body, the protruding portion (71p) is brought into abutment with the surface portion (16f2) provided at a position where the surface portion of the first apparatus main body overlaps with the protruding portion of the second cartridge when viewed in the mounting direction, thereby the second cartridge is restricted to be moved in the mounting direction and is prevented from being mounted on the first apparatus main body, and
wherein by moving the first cartridge in the mounting direction to mount the first cartridge on the first apparatus main body, the first cartridge is allowed to be mounted on the first apparatus main body without being restricted by the surface portion (16f2).

2. The erroneous mounting prevention system according to claim 1,
wherein the second restricted portion (71d) is a positioned portion by which the second cartridge (B2) is positioned relative to the second apparatus main body (A2) in the direction in which the second cartridge is mounted, and
wherein the first restricted portion (71d) is a positioned portion by which the first cartridge (B1) is positioned relative to the first apparatus main body (A1) in the direction in which the first cartridge is mounted.

3. The erroneous mounting prevention system according to claim 1 or 2,
wherein the restriction member (16g) is provided to be rotatable around a rotational axis extending in a direction intersecting the direction in which the second cartridge (B2) is mounted, and
wherein the restriction member (16g) includes a second abutted surface (16g2) with which the protruding portion (71p) of the second cartridge is brought into abutment and a first abutted surface (16g3) with which the first restricted portion (71d) of the first cartridge is brought into abutment, the second abutted surface (16g2) being configured to generate a rotational moment in a direction for rotating the restriction member (16g) from the restriction position to the non-restriction position when the protruding portion is brought into abutment therewith, the first abutted surface (16g3) being configured to generate a rotational moment in a direction for rotating the restriction member (16g) from the non-restriction position to the restriction position when the first restricted portion (71d) is brought into abutment therewith.

4. The erroneous mounting prevention system according to any preceding claim, further comprising a third apparatus main body (A3) and a third cartridge (B3),
wherein the third apparatus main body (A3) includes, assuming that the recessed portion (16fl) is a first recessed portion (16fl), a second recessed portion (16f3) at a position different from a position corresponding to the first recessed portion (16f1) of the second apparatus main body,
wherein the third cartridge includes, assuming that the protruding portion (71p) is a first protruding portion (71p), a second protruding portion (71q3) at a position different from a position corresponding to the first protruding portion (71p) of the second cartridge,
wherein by moving the third cartridge in the mounting direction to mount the third cartridge on the second apparatus main body, the second protruding portion (71q3) is unable to pass through the first recessed portion (16fl), so that the third cartridge is prevented from being mounted on the second apparatus main body,
wherein by moving the third cartridge in the mounting direction to mount the third cartridge on the first apparatus main body, the second protruding portion (71q3) is brought into abutment with the surface portion (16f2), so that the third cartridge is prevented from being mounted on the first apparatus main body, and
wherein by moving the third cartridge in the mounting direction to mount the third cartridge on the third apparatus main body, the second protruding portion (71q3) passes through the second recessed portion (16f3), so that the third cartridge is allowed to be mounted on the third apparatus main body.

## Patentansprüche

1. System zur Verhinderung von Fehlmontage, umfassend:
eine erste Kartusche (B1), die einen ersten beschränkten Abschnitt (71d) enthält;
eine zweite Kartusche (B2), die einen vorstehenden Abschnitt (71p) und einen zweiten beschränkten Abschnitt (71d) enthält;
einen ersten Vorrichtungshauptkörper (A1), der ausgebildet ist, zuzulassen, dass die erste Kartusche daran montiert wird und zu verhindern, dass die zweite Kartusche daran montiert wird; und
einen zweiten Vorrichtungshauptkörper (A2), der ausgebildet ist, zu verhindern, dass die erste Kartusche montiert wird und zuzulassen, dass die zweite Kartusche am zweiten Vorrichtungshauptkörper montiert wird, wobei der zweite Vorrichtungshauptkörper einen vertieften Abschnitt (16f1) und ein Beschränkungselement (16g) enthält, das ausgebildet ist, zwischen einer Beschränkungsposition, an der die erste und zweite Kartusche nicht montiert werden können, und einer Nichtbeschränkungsposition, an der die erste und die zweite Kartusche montiert werden können, bewegbar zu sein, **dadurch gekennzeichnet, dass**:
die erste Kartusche an einer einer Position des vorstehenden Abschnitts (71p) der zweiten Kartusche entsprechenden Position keinen Abschnitt enthält, der dem vorstehenden Abschnitt (71p) der zweiten Kartusche entspricht, und der erste Vorrichtungshauptkörper an einer Position, die dem vertieften Abschnitt (16f1) des zweiten Vorrichtungshauptkörpers entspricht, einen Flächenabschnitt (16f2) und an einer einer Position des Beschränkungselements (16g) des zweiten Vorrichtungshauptkörpers entsprechenden Position kein Element enthält, das dem Beschränkungselement (16g) des zweiten Vorrichtungshauptkörpers entspricht,
wobei durch Bewegen der zweiten Kartusche in eine Montagerichtung zum Montieren der zweiten Kartusche am zweiten Vorrichtungshauptkörper der vorstehende Abschnitt (71p) den vertieften Abschnitt (16f1) durchläuft und dann in Kontakt mit dem Beschränkungselement (16g) gebracht wird, um das Beschränkungselement (16g) von der Beschränkungsposition zur Nichtbeschränkungsposition zu bewegen, wodurch der zweite beschränkte Abschnitt (71d) einen Bereich durchläuft, in dem sich das Beschränkungselement (16g) befindet, wenn das Beschränkungselement sich in der Beschränkungsposition befindet, sodass die zweite Kartusche am zweiten Vorrichtungshauptkörper montiert werden kann,
wobei durch Bewegen der ersten Kartusche in die Montagerichtung zum Montieren der ersten Kartusche am zweiten Vorrichtungshauptkörper der erste beschränkte Abschnitt (71d) in Kontakt mit dem Beschränkungselement (16g) gebracht wird, das sich an der Beschränkungsposition befindet, wodurch die erste Kartusche nicht in die Montagerichtung bewegt werden kann und daran gehindert wird, am zweiten Vorrichtungshauptkörper montiert zu werden,
wobei durch Bewegen der zweiten Kartusche in die Montagerichtung zum Montieren der zweiten Kartusche am ersten Vorrichtungshauptkörper der vorstehende Abschnitt (71p) in Kontakt mit dem Flächenabschnitt (16f2) gebracht wird, der an einer Position vorgesehen ist, an der der Flächenabschnitt des ersten Vorrichtungshauptkörpers den vorstehenden Abschnitt der zweiten Kartusche in der Montagerichtung überlappt, wodurch die zweite Kartusche nicht in die Montagerichtung bewegt werden kann und daran gehindert wird, am ersten Vorrichtungshauptkörper montiert zu werden, und
wobei durch Bewegen der ersten Kartusche in die Montagerichtung zum Montieren der ersten Kartusche am ersten Vorrichtungshauptkörper die erste Kartusche am ersten Vorrichtungshauptkörper montiert werden kann, ohne durch den Flächenabschnitt (16f2) beschränkt zu werden.

2. System zur Verhinderung von Fehlmontage nach Anspruch 1,
wobei der zweite beschränkte Abschnitt (71d) ein Positionierungsabschnitt ist, durch den die zweite Kartusche (B2) relativ zum zweiten Vorrichtungshauptkörper (A2) in die Richtung, in der die zweite Kartusche montiert wird, positioniert ist, und
wobei der erste beschränkte Abschnitt (71d) ein Positionierungsabschnitt ist, durch den die erste Kartusche (B1) relativ zum ersten Vorrichtungshauptkörper (A1) in die Richtung, in der die erste Kartusche montiert wird, positioniert ist.

3. System zur Verhinderung von Fehlmontage nach Anspruch 1 oder 2,
wobei das Beschränkungselement (16g) vorgesehen ist, um eine Rotationsachse rotierbar zu sein, die sich in eine Richtung erstreckt, die die Richtung schneidet, in der die zweite Kartusche (B2) montiert wird, und
wobei das Beschränkungselement (16g) eine zweite anliegende Fläche (16g2) enthält, mit der der vorstehende Abschnitt (71p) der zweiten Kartusche in Kontakt gebracht wird, und eine erste anliegende Fläche (16g3), mit der der erste beschränkte Abschnitt (71d) der ersten Kartusche in Kontakt gebracht wird, wobei die zweite anliegende Fläche (16g2) ausgebildet ist, ein Drehmoment in eine Richtung zum Rotieren des Beschränkungselements (16g) von der Beschränkungsposition zur Nichtbeschränkungsposition zu erzeugen, wenn der vorstehende Abschnitt mit ihr in Kontakt gebracht wird, wobei die erste anliegende Fläche (16g3) ausgebildet ist, ein Drehmoment in eine Richtung zum Rotieren des Beschränkungselements (16g) von der Nichtbeschränkungsposition zur Beschränkungsposition zu erzeugen, wenn der erste beschränkte Abschnitt (71d) mit ihr in Kontakt gebracht wird.

4. System zur Verhinderung von Fehlmontage nach einem der vorangegangenen Ansprüche, ferner umfassend einen dritten Vorrichtungshauptkörper (A3) und eine dritte Kartusche (B3),
wobei, wenn man davon ausgeht, dass der vertiefte Abschnitt (16f1) ein erster vertiefter Abschnitt ist (16f1), der dritte Vorrichtungshauptkörper (A3) einen zweiten vertieften Abschnitt (16f3) an einer Position enthält, die sich von einer dem ersten vertieften Abschnitt (16f1) des zweiten Vorrichtungshauptkörpers entsprechenden Position unterscheidet,
wobei, wenn man davon ausgeht, dass der vorstehende Abschnitt (71p) ein erster vorstehender Abschnitt (71p) ist, die dritte Kartusche einen zweiten vorstehenden Abschnitt (71q3) an einer Position enthält, die sich von einer dem ersten vorstehenden Abschnitt (71p) der zweiten Kartusche entsprechenden Position unterscheidet,
wobei durch Bewegen der dritten Kartusche in die Montagerichtung zum Montieren der dritten Kartusche am zweiten Vorrichtungshauptkörper der zweite vorstehende Abschnitt (71q3) den ersten vertieften Abschnitt (16f1) nicht durchlaufen kann, sodass die dritte Kartusche daran gehindert wird, am zweiten Vorrichtungshauptkörper montiert zu werden,
wobei durch Bewegen der dritten Kartusche in die Montagerichtung zum Montieren der dritten Kartusche am ersten Vorrichtungshauptkörper der zweite vorstehende Abschnitt (71q3) mit dem Flächenabschnitt (16f2) in Kontakt gebracht wird, sodass die dritte Kartusche daran gehindert wird, am ersten Vorrichtungshauptkörper montiert zu werden, und
wobei durch Bewegen der dritten Kartusche in die Montagerichtung zum Montieren der dritten Kartusche am dritten Vorrichtungshauptkörper der zweite vorstehende Abschnitt (71q3) den zweiten vertieften Abschnitt (16f3) durchläuft, sodass die dritte Kartusche am dritten Vorrichtungshauptkörper montiert werden kann.

## Revendications

1. Système de prévention de montage erroné, comprenant :
une première cartouche (B1) comprenant une première partie restreinte (71d) ;
une deuxième cartouche (B2) comprenant une partie en saillie (71p) et une seconde partie restreinte (71d) ;
un premier corps principal d'appareil (A1) configuré pour autoriser un montage de la première cartouche sur ce dernier et pour empêcher un montage de la deuxième cartouche sur ce dernier ; et
un deuxième corps principal d'appareil (A2) configuré pour empêcher un montage de la première cartouche sur le deuxième corps principal d'appareil et pour autoriser un montage de la deuxième cartouche sur ce dernier, le deuxième corps principal d'appareil comprenant une partie évidée (16f1) et un élément de restriction (16g) configuré pour être mobile entre une position de restriction dans laquelle les première et deuxième cartouches sont restreintes par rapport à un montage sur ce dernier et une position de non-restriction dans laquelle les première et deuxième cartouches ne sont pas restreintes par rapport à un montage sur ce dernier, **caractérisé en ce que** :
la première cartouche ne comprend aucune partie correspondant à la partie en saillie (71p) de la deuxième cartouche au niveau d'une position correspondant à une position de la partie en saillie (71p) de la deuxième cartouche, et le premier corps principal d'appareil comprend une partie de surface (16f2) au niveau d'une position correspondant à la partie évidée (16f1) du deuxième corps principal d'appareil et ne comprend aucun élément correspondant à l'élément de restriction (16g) du deuxième corps principal d'appareil au niveau d'une position correspondant à une position de l'élément de restriction (16g) du deuxième corps principal d'appareil,
dans lequel, en déplaçant la deuxième cartouche dans un sens de montage pour monter la deuxième cartouche sur le deuxième corps principal d'appareil, la partie en saillie (71p) passe à travers la partie évidée (16f1) et est ensuite amenée en butée contre l'élément de restriction (16g) pour déplacer l'élément de restriction (16g) de la position de restriction à la position de non-restriction, ce par quoi la seconde partie restreinte (71d) passe à travers une région dans laquelle l'élément de restriction (16g) est situé lorsque l'élément de restriction est à la position de restriction, de façon à autoriser un montage de la deuxième cartouche sur le deuxième corps principal d'appareil,
dans lequel, en déplaçant la première cartouche dans le sens de montage pour monter la première cartouche sur le deuxième corps principal d'appareil, la première partie restreinte (71d) est amenée en butée contre l'élément de restriction (16g) situé à la position de restriction, ce par quoi un déplacement de la première cartouche dans le sens de montage est restreint et un montage de cette dernière sur le deuxième corps principal d'appareil est empêché,
dans lequel, en déplaçant la deuxième cartouche dans le sens de montage pour monter la deuxième cartouche sur le premier corps principal d'appareil, la partie en saillie (71p) est amenée en butée contre la partie de surface (16f2) disposée à une position au niveau de laquelle la partie de surface du premier corps principal d'appareil chevauche la partie en saillie de la deuxième cartouche lorsqu'observée dans le sens de montage, ce par quoi un déplacement de la deuxième cartouche dans le sens de montage est restreint et un montage de cette dernière sur le premier corps principal d'appareil est empêché, et
dans lequel, en déplaçant la première cartouche dans le sens de montage pour monter la première cartouche sur le premier corps principal d'appareil, un montage de la première cartouche sur le premier corps principal d'appareil est autorisé sans être restreint par la partie de surface (16f2).

2. Système de prévention de montage erroné selon la revendication 1,
dans lequel la seconde partie restreinte (71d) est une partie positionnée par laquelle est positionnée la deuxième cartouche (B2) par rapport au deuxième corps principal d'appareil (A2) dans le sens dans lequel est montée la deuxième cartouche, et
dans lequel la première partie restreinte (71d) est une partie positionnée par laquelle est positionnée la première cartouche (B1) par rapport au premier corps principal d'appareil (A1) dans le sens dans lequel est montée la première cartouche.

3. Système de prévention de montage erroné selon la revendication 1 ou 2,
dans lequel l'élément de restriction (16g) est prévu pour être mobile en rotation autour d'un axe de rotation s'étendant dans une direction coupant le sens dans lequel est montée la deuxième cartouche (B2), et
dans lequel l'élément de restriction (16g) comprend une seconde surface de butée (16g2) contre laquelle la partie en saillie (71p) de la deuxième cartouche est amenée en butée et une première surface de butée (16g3) contre laquelle la première partie restreinte (71d) de la première cartouche est amenée en butée, la seconde surface de butée (16g2) étant configurée pour générer un moment de rotation dans un sens pour tourner l'élément de restriction (16g) de la position de restriction à la position de non-restriction lorsque la partie en saillie est amenée en butée contre cette dernière, la première surface de butée (16g3) étant configurée pour générer un moment de rotation dans un sens pour tourner l'élément de restriction (16g) de la position de non-restriction à la position de restriction lorsque la première partie restreinte (71d) est amenée en butée contre cette dernière.

4. Système de prévention de montage erroné selon l'une quelconque des revendications précédentes, comprenant en outre un troisième corps principal d'appareil (A3) et une troisième cartouche (B3),
dans lequel le troisième corps principal d'appareil (A3) comprend, en supposant que la partie évidée (16f1) soit une première partie évidée (16f1), une seconde partie évidée (16f3) au niveau d'une position différente d'une position correspondant à la première partie évidée (16f1) du deuxième corps principal d'appareil,
dans lequel la troisième cartouche comprend, en supposant que la partie en saillie (71p) soit une première partie en saillie (71p), une seconde partie en saillie (71q3) au niveau d'une position différente d'une position correspondant à la première partie en saillie (71p) de la deuxième cartouche,
dans lequel, en déplaçant la troisième cartouche dans le sens de montage pour monter la troisième cartouche sur le deuxième corps principal d'appareil, la seconde partie en saillie (71q3) ne peut pas passer à travers la première partie évidée (16f1), de façon à empêcher un montage de la troisième cartouche sur le deuxième corps principal d'appareil,
dans lequel, en déplaçant la troisième cartouche dans le sens de montage pour monter la troisième cartouche sur le premier corps principal d'appareil, la seconde partie en saillie (71q3) est amenée en butée contre la partie de surface (16f2), de façon à empêcher un montage de la troisième cartouche sur le premier corps principal d'appareil, et
dans lequel, en déplaçant la troisième cartouche dans le sens de montage pour monter la troisième cartouche sur le troisième corps principal d'appareil, la seconde partie en saillie (71q3) passe à travers la seconde partie évidée (16f3), de façon à permettre un montage de la troisième cartouche sur le troisième corps principal d'appareil.
